# EUROPÄISCHE PATENTSCHRIFT

(11) **EP 3 632 190 B1**
(45) Veröffentlichungstag und Bekanntmachung des Hinweises auf die Patenterteilung: **28.05.2025**
(21) Anmeldenummer: 18734486.6
(22) Anmeldetag: 19.06.2018
(51) Int. Cl.: H05K 1/14, H05K 1/03, H05K 1/05, H05K 1/18, H05K 3/32, H01L 23/498, H01L 23/538, H01L 23/00, H01L 25/07

(54) **ELEKTRISCHE BAUGRUPPE UND VERFAHREN ZUR HERSTELLUNG EINER ELEKTRISCHEN BAUGRUPPE**
ELECTRICAL ASSEMBLY AND METHOD FOR MAUFACTURING AN ELECTRICAL ASSEMBLY
ASSEMBLAGE ÉLECTRIQUE ET PROCÉDÉ DE FABRICATION DE L'ASSEMBLAGE ÉLECTRIQUE

(30) Priorität: 18.07.2017 DE 102017212233
(43) Veröffentlichungstag der Anmeldung: 08.04.2020
(73) Patentinhaber: Siemens Aktiengesellschaft, 80333 München (DE)
(72) Erfinder: BLANK, Rene, 12249 Berlin (DE); FRANKE, Martin, 14089 Berlin (DE); FRÜHAUF, Peter, 14612 Falkensee (DE); NERRETER, Stefan, 15754 Heidesee OT Blossin (DE); KNOFE, Rüdiger, 14513 Teltow (DE); MÜLLER, Bernd, 16259 Falkenberg (DE); STROGIES, Jörg, 14163 Berlin (DE); WILKE, Klaus, 12527 Berlin (DE)
(74) Vertreter: Siemens Patent Attorneys
(86) Internationale Anmeldenummer: PCT/EP2018/066169
(87) Internationale Veröffentlichungsnummer: WO 2019/015901

(56) Entgegenhaltungen:
- EP-A1- 0 652 692
- WO-A1-2013/130363
- US-A1- 2015 049 443

## Beschreibung

Die Erfindung betrifft eine elektrische oder elektronische Baugruppe mit einem flexiblen Verdrahtungsträger und ein Verfahren zum Herstellen einer solchen elektrischen Baugruppe.

Heutzutage werden elektrische und elektronische Baugruppen und Schaltanordnungen nicht nur zunehmend komplexer, sondern sie sollen dabei auch weiter miniaturisiert und in ihrer Leistungsfähigkeit gesteigert werden. Durch diese Kombination von Anforderungen ergeben sich verschiedene Probleme in der Aufbau- und Verbindungstechnik sowie beim Betrieb der entsprechenden Baugruppen oder Schaltungen. Es kommen beispielsweise zunehmend Aufbaukonzepte zum Einsatz, bei denen beispielsweise Halbleiterelemente direkt montiert werden, also nicht in einem entsprechenden Gehäuse gekapselt sind. Es ist bisher üblich, Anbindungen oder Kontaktierungen der Halbleiterelemente planar durch stoffschlüssige Verbindungen mechanisch, thermisch und elektrisch zu verbinden. So kann sich eine Toleranzkette über eine Vielzahl von Bauelementen hinweg aufbauen. Ein Einhalten einer vorgegebenen Schlusstoleranz, zum Beispiel einer möglichen Fügeverbindungshöhe an einer Halbleiteroberseite, stellt häufig kritische und schwer einzuhaltende Forderungen an die toleranzbehafteten Bauelemente. Hier wird heutzutage bereits häufig die Grenze einer sinnvollen, mit vertretbaren Kosten effizient realisierbaren Fertigung erreicht.

Eine weitere zunehmend relevanter werdende Herausforderung stellt ein thermomechanisches Verhalten solcher Baugruppen oder Schaltungen dar. Aus funktionellen Gründen müssen häufig Werkstoffe oder Bauelemente mit stark unterschiedlichen thermischen Ausdehnungskoeffizienten eingesetzt werden. Dies können beispielsweise Glasfaser- oder Epoxidwerkstoffe für organische Verdrahtungsträger mit einem thermischen Ausdehnungskoeffizient von etwa 15-18×10⁻⁶ K⁻¹, Aluminiumoxidkeramiken mit einem thermischen Ausdehnungskoeffizienten von etwa 7×10-⁶ K⁻¹ oder auch das häufig für Kühlkörper verwendete Aluminium mit einem thermischen Ausdehnungskoeffizienten von etwa 23×10⁻⁶ K⁻¹ sein. Bei herkömmlichen Baugruppen oder Aufbauten können diese oder derartige Materialien stoffschlüssig miteinander verbunden sein, um eine mechanische, thermische und elektrische Funktionalität zu sichern. Insbesondere bei Temperaturen jenseits der Fügetemperaturen und/oder bei Temperaturunterschieden zwischen den verschiedenen Materialien, wie sie bei einem regulären Betrieb auftreten können, können die unterschiedlichen thermischen Ausdehnungskoeffizienten, das heißt die Unterschiede in dem jeweiligen thermomechanischen Verhalten, zu unerwünschten Fehlausdehnungen, also schädigungswirksamen Ausdehnungsunterschieden, führen.

Ein bekannter Lösungsansatz für diese Probleme besteht in einer stofflich-geometrischen Optimierung. Hier wird versucht, durch geschickte Anordnung und Auswahl unterschiedlicher Materialien die genannten Probleme zu beherrschen. Beispielsweise können bei erwarteten stark unterschiedlichen Ausdehnungen beziehungsweise Ausdehnungsänderungen Fügewerkstoffe mit besonders hoher Wechsellastfähigkeit, zum Beispiel leistungsgesteigerte Lotwerkstoffe oder Sinterwerkstoffe, eingesetzt oder Materialien mit stark unterschiedlichen Ausdehnungskoeffizienten von vornherein vermieden werden. Dies kann jedoch zu erheblich gesteigerten Kosten und/oder einer eingeschränkten Funktionalität führen. Dieser Lösungsansatz ist zudem nicht beliebig mit der zunehmenden Miniaturisierung und Leistungssteigerung skalierbar.

Die WO 03 / 0 323 91 A2 beschreibt ein Verfahren zum Formen eines Aufbaus (Package) für elektronische Komponenten und einen derartigen Aufbau. Der Aufbau weist mehrere schichtartig gestapelte Elemente auf, einschließlich eines Kühlelements, eines flexiblen Substrats, welches eine elektrisch leitfähige Schicht und eine elektronische Komponente trägt, eines elektrisch isolierenden Füllmaterials (gap filler) und eines Deckels. Auf diese Stapelanordnung wird ein Druck ausgeübt, um einen mechanischen Kontakt zwischen dem flexiblen Substrat und dem Kühlkörper herzustellen.

Aus der US 2015/049443 A1 ist eine Chipanordnung bekannt, die einen ersten Träger; mindestens einen Chip, der über dem ersten Träger angeordnet ist; eine flexible Struktur mit einer Verdrahtungsschichtstruktur; und eine Kontaktstruktur, die zwischen dem ersten Träger und der Verdrahtungsschichtstruktur angeordnet ist, wobei der mindestens eine Chip über die Verdrahtungsschichtstruktur und die Kontaktstruktur elektrisch an den ersten Träger gekoppelt ist, aufweisen kann.

Aufgabe der vorliegenden Erfindung ist es, eine elektrische Baugruppe mit besonders gutem thermomechanischen Verhalten bereitzustellen, die mit besonders geringem Aufwand präzise zu fertigen ist und dabei eine flexible, auch komplexe Funktionalität ermöglicht.

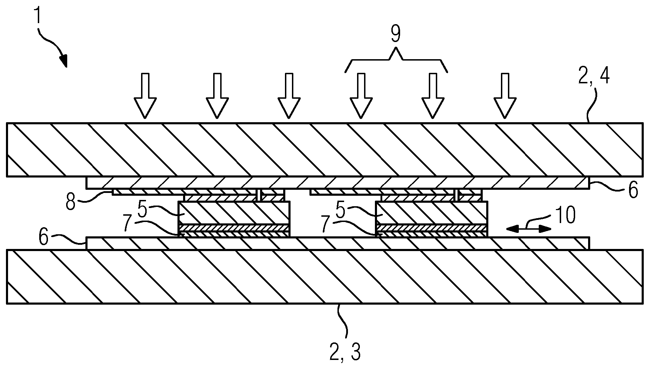

Diese Aufgabe wird erfindungsgemäß durch die Gegenstände der unabhängigen Patentansprüche gelöst. Vorteilhafte Ausgestaltungen und Weiterbildungen der Erfindung sind in den abhängigen Patentansprüchen sowie in der Beschreibung und in der Zeichnung angegeben.

Eine erfindungsgemäße elektrische Baugruppe weist wenigstens ein elektronisches Schaltelement auf, welches an seiner Unterseite elektrisch kontaktiert und auf einem flexiblen ersten Verdrahtungsträger der elektrischen Baugruppe angeordnet ist. Erfindungsgemäß ist es dabei vorgesehen, dass das elektronische Schaltelement zusätzlich auf einer der Unterseite gegenüberliegenden Oberseite elektrisch kontaktiert ist. Zudem weist die elektrische Baugruppe einen zweiten Verdrahtungsträger auf, der dem ersten Verdrahtungsträger gegenüberliegend an der oberseitigen elektrischen Kontaktierung des elektronischen Schaltelements angeordnet ist. Erfindungsgemäß sind der erste und der zweite Verdrahtungsträger jeweils wenigstens zum Teil, also zumindest bereichsweise, aus einem dauerelastischen, elektrisch isolierenden, thermisch leitfähigen Material gebildet.

Durch die beidseitige elektrische Kontaktierung des Schaltelementes können vorteilhaft besonders komplexe Funktionalitäten der elektrischen Baugruppe insgesamt und des elektronischen Schaltelements im Speziellen realisiert werden. Die beidseitige elektrische Kontaktierung kann ebenso eine besonders große Flexibilität bei der Realisierung oder Implementierung jeweils gewünschter Funktionalitäten bieten. Gerade für leistungselektronische Komponenten können die jeweiligen Leitungsquerschnitte nicht beliebig verringert werden, sodass durch die beidseitige elektrische Kontaktierung mehr Leitungen oder Anschlüsse an das elektronische Schaltelement geführt werden können. Ein weiterer Vorteil der beidseitigen elektrischen Kontaktierung und der auf beiden Seiten, also unterhalb der Unterseite und oberhalb der Oberseite des elektronischen Schaltelements angeordneten dauerelastischen, thermisch leitfähigen Materialbereiche oder Schichten der jeweiligen Verdrahtungsträger kann zudem bei einem Betrieb der elektrischen Baugruppe entstehende Wärme von dem elektronischen Schaltelement in beide gegenüberliegenden Richtungen abgeführt werden. Der vorgeschlagene Aufbau kann also ein verbessertes Temperatur- beziehungsweise Wärmemanagement bieten und somit eine höhere elektrische und/oder thermische Belastbarkeit und/oder Leistungsdichte innerhalb der elektrischen Baugruppe beziehungsweise innerhalb des elektronischen Schaltelements beschädigungsfrei ermöglichen.

Zum Bewältigen der eingangs genannten Probleme und Herausforderungen nutzt die vorliegend vorgeschlagene Lösung eine Integration mehrerer Funktionen oder Funktionalitäten in die Verdrahtungsträger. So ermöglicht die Elastizität der Verdrahtungsträger - beziehungsweise der entsprechenden dauerelastischen Materialbereiche der Verdrahtungsträger - während eines Herstellungs-, Montage- oder Fügeprozesses der elektrischen Baugruppe aufgebrachte, insbesondere zumindest im Wesentlichen senkrecht zu der Unterseite und der Oberseite des elektronischen Schaltelements aufgebrachte, Druckkräfte beschädigungsfrei aufzunehmen. Dies ermöglicht also eine höhenadaptive Annäherung der Fügepartner, also der Bauelemente, der elektrischen Baugruppe. Mit anderen Worten kann die Elastizität der Verdrahtungsträger für einen Toleranzausgleich, also das Einhalten einer vorgegebenen Schlusstoleranz der gesamten elektrischen Baugruppe ausgenutzt werden. Eine entsprechende Toleranzkette der elektrischen Baugruppe wird durch das aufgrund der Elastizität der Verdrahtungsträger flexible Schlussmaß der elektrischen Baugruppe vorteilhaft deutlich entspannt, ist also mit geringerem Aufwand einhaltbar.

Zusätzlich zu diesem Toleranzausgleich bietet die Elastizität der Verdrahtungsträger die Möglichkeit und den Vorteil eines Ausgleichs von thermischen Ausdehnungsdifferenzen, also unterschiedlichen thermischen Ausdehnungskoeffizienten und/oder unterschiedlichen Temperaturen, der Fügepartner der elektrischen Baugruppe, insbesondere unter elektrischer und/oder thermischer Wechsellast. Solche Ausdehnungsdifferenzen können bei herkömmlichen Baugruppen oder Aufbauten schädigungswirksam werden, das heißt zu einer Beschädigung oder zu einer beschleunigten Alterung der jeweiligen Baugruppe beziehungsweise des jeweiligen Aufbaus oder einzelner Bauelemente führen. Die Elastizität der Verdrahtungsträger verhindert oder verringert einen Aufbau von, insbesondere thermisch verursachten, mechanischen Spannungen beziehungsweise von mechanischem Stress innerhalb der elektrischen Baugruppe.

Besonders vorteilhaft kann das jeweilige dauerelastische Material der Verdrahtungsträger eine mechanische Flexibilität beziehungsweise Elastizität in unterschiedliche Raumrichtungen bieten. Das bedeutet, dass das dauerelastische Material nicht nur in einer ersten Richtung senkrecht zu der Unterseite und der Oberseite beziehungsweise den entsprechenden Flächen oder einer entsprechenden Haupterstreckungsebene des elektronischen Schaltelements beschädigungsfrei verformbar ist, sondern zumindest auch in einer zweiten Richtung, die sich bevorzugt senkrecht zu der ersten Richtung erstrecken kann. Mit anderen Worten kann das jeweilige dauerelastische Material also auch beschädigungsfrei Verformungen oder Ausdehnungsdifferenzen in oder parallel zu einer Verbindungsebene zwischen zwei Bauelementen der elektrischen Baugruppe aufnehmen. Diese Verbindungsebene kann beispielsweise parallel zu der Oberseite und der Unterseite des beziehungsweise der Haupterstreckungsebene des elektronischen Schaltelements angeordnet sein.

Die elektrische Baugruppe kann ein Stapel von Bauelementen sein, also eine stapelartige Struktur oder einen stapelartigen Aufbau aufweisen. Die einzelnen Bauelemente können insbesondere eine flächige Ausdehnung, also eine schichtartige Form oder Gestalt aufweisen, also jeweils eine Schicht oder einen Teil einer Schicht des Stapels beziehungsweise der elektrischen Baugruppe bilden. Das dauerelastische Material kann dann beschädigungsfrei sowohl senkrecht zu den einzelnen Schichten, also in Stapelrichtung, als auch parallel zu den Schichten oder Lagen, also zumindest im Wesentlichen senkrecht zur Stapelrichtung beschädigungsfrei verformbar sein. So kann sich beispielsweise ein außenliegendes, also ein außen an der elektrischen Baugruppe angeordnetes oder eine Außenseite der elektrischen Baugruppe bildendes Kühlelement sich quer zur Stapelrichtung bei einem Betrieb der elektrischen Baugruppe stärker ausdehnen, also eine größere relative Längenänderung aufweisen, als beispielsweise die weiter innen liegende Kontaktierung oder das ebenfalls weiter innen angeordnete elektronische Schaltelement.

Diese Ausdehnungsdifferenzen werden von dem dazwischenliegenden dauerelastischen Material aufgenommen, also ausgeglichen, sodass hierdurch eine Beschädigung, beispielsweise ein Reißen, des Kühlelements, der Kontaktierung, des Schaltelements oder entsprechender Verbindungen vermieden werden kann.

Die vorliegende Erfindung zeigt also auf, wie auch komplexe elektrische Baugruppen mit verbessertem thermomechanischen Verhalten und höherer elektrischer und/oder thermischer Belastbarkeit realisiert werden können, wobei gleichzeitig mit im Gegensatz zu bekannten Methoden relativ geringem Aufwand vorgegebene Toleranzen für eine Größe, insbesondere eine Höhe, der elektrischen Baugruppe eingehalten werden können. Durch die beidseitige Verwendung des dauerelastischen Materials können vorteilhaft in ihrer jeweiligen individuellen Funktionalität besonders leistungsfähige Materialien für andere Bauelemente der elektrischen Baugruppe verwendet werden, auch wenn diese signifikant unterschiedliche thermomechanische Verhalten beziehungsweise thermische Ausdehnungskoeffizienten haben. So können also bisher notwendige Kompromisse in der Materialwahl vermieden und eine insgesamt verbesserte Leistung der elektrischen Baugruppe erreicht werden.

Eine elektrische oder elektronische Baugruppe kann im Sinne der vorliegenden Erfindung als konstruktiver und/oder funktioneller Verbund beziehungsweise als konstruktive und/oder funktionelle Einheit aus integrierten und/oder diskreten, aktiven und/oder passiven Bauteilen oder Bauelementen verstanden werden diese Bauteile oder Bauelemente können durch ein elektrisches Leitungsnetz elektrisch miteinander verbunden sein. Das dauerelastische, elektrisch isolierende, thermisch leitfähigen Material muss dabei keinen Anteil an einer elektrischen oder elektronischen Signal- oder datenverarbeitenden oder -weiterleitenden Funktion der elektrischen Baugruppe haben. Es kann beispielsweise als Träger für zumindest einen Teil des elektrischen Leitungsnetzes, eine elektrische Kontaktierung und/oder wenigstens ein anderes Bauelement der elektrischen Baugruppe dienen.

Das dauerelastische Material kann bevorzugt einen Teilbereich, insbesondere eine Schicht, des jeweiligen Verdrahtungsträgers bilden. Ein Rest oder übriger Bereich des jeweiligen Verdrahtungsträgers kann also aus einem anderen Material gebildet sein. Hierdurch kann vorteilhaft eine mechanische Stabilität, beispielsweise eine Biegesteifigkeit, der elektrischen Baugruppe verbessert werden, ohne die durch den Einsatz des dauerhaft elastischen Materials erzielten Vorteile aufzugeben.

Das dauerelastische, elektrisch isolierende, thermisch gut leitfähige Material kann aus bekannten Materialien mit diesen Eigenschaften ausgewählt werden - im Einzelfall beispielsweise je nach individuellen Anforderungen. Die vorliegende Erfindung ist also nicht auf eine bestimmte Komposition dieses beziehungsweise eines solchen Materials gerichtet, da grundsätzlich geeignete Materialien bekannt sind.

Bauelemente der vorliegenden elektrischen Baugruppe sind beispielsweise das elektronische Schaltelement und die Verdrahtungsträger. Auch die elektrische Kontaktierung beziehungsweise eine entsprechende elektrische Kontaktierungsschicht kann als Bauelement verstanden werden. Darüber hinaus kann die elektrische Baugruppe weitere Bauelemente, beispielsweise Kühlelemente, mechanische Abstützungen, Sensoren und dergleichen mehr, aufweisen.

Erfindungsgemäß weist das elektronische Schaltelement wenigstens einen Leistungshalbleiter auf. Das elektronische Schaltelement kann mit anderen Worten also einen oder mehrere Chips einer Leistungselektronik umfassen. Die vorliegende Erfindung kann für elektrische Baugruppen, die leistungselektronische Komponenten oder Elemente aufweisen oder einerseits eine Leistungselektronik und andererseits Logik- oder Berechnungskomponenten miteinander kombinieren beziehungsweise integrieren besonders vorteilhaft eingesetzt werden. Durch den Einsatz von leistungselektronischen Komponenten fällt innerhalb einer solchen Baugruppe eine erhöhte Verlustleistung an, welche eine effektive Handhabung des thermomechanischen Verhaltens der Baugruppe besonders wichtig macht. Durch diese relativ hohe Verlustleistung verursachte relativ hohe Temperaturen wirken sich im Allgemeinen nachteilig auf Logikschaltungen oder Berechnungseinrichtungen innerhalb der Baugruppe aus. Nichtsdestotrotz ist zunehmend eine erhöhte räumliche Packungsdichte - auch unterschiedlicher Komponenten - angestrebt, um beispielsweise die Miniaturisierung voranzutreiben und Signallaufzeiten zu verringern. Praktische Anwendungsfälle, in denen die vorliegende Erfindung vorteilhaft eingesetzt werden kann, sind beispielsweise Photovoltaikanlagen, Inverter, Ansteuerungen und Leistungsverteilungen für Elektromotoren und dergleichen mehr.

In weiterer vorteilhafter Ausgestaltung der vorliegenden Erfindung ist das dauerelastische Material des ersten und/oder des zweiten Verdrahtungsträgers auf einen metallischen Träger aufgedrückt. Das dauerelastische Material kann also insbesondere kraftschlüssig mit dem jeweiligen metallischen Träger verbunden sein. Dabei kann insbesondere auf eine stoffschlüssige Verbindung verzichtet sein. Das Aufdrücken bedeutet, dass ein mechanischer und thermischer, insbesondere wärmeleitender, Kontakt zwischen dem dauerelastischen Material und dem jeweiligen metallischen Träger durch eine Kraft hergestellt beziehungsweise sichergestellt wird, die senkrecht zu einer Verbindungs- oder Kontaktfläche beziehungsweise -ebene zwischen dem dauerelastischen Material und dem jeweiligen metallischen Träger wirkt. Die Kraft kann dabei gleichmäßig über die gesamte Fläche dieser Kontaktebene ausgeübt werden oder es können vorgegebene Kontaktbereiche, also Teilbereiche der Gesamt-Kontaktfläche, kraftschlüssig aneinandergepresst werden.

Aufgrund der Elastizität, also der Verformbarkeit des dauerelastischen Materials kann hier vorteilhaft auch ohne eine stoffschlüssige Verbindung ein optimaler Kontakt zwischen dem dauerelastischen Material und dem metallischen Träger hergestellt und sichergestellt werden, da beispielsweise Unebenheiten oder Baulichkeiten des jeweiligen metallischen Trägers durch das dauerelastische Material verfüllt beziehungsweise ausgeglichen werden können. Da das dauerelastische Material auch thermisch leitfähig ist, kann so in der elektrischen Baugruppe entstehende Ab- oder Verlustwärme durch das dauerelastische Material besonders effektiv und effizient an den metallischen Träger weitergeleitet beziehungsweise abgeführt werden.

Der metallische Träger kann diese Wärme dann aufgrund seiner besonders guten thermischen Leitfähigkeit besonders effektiv und effizient verteilen, weiterleiten oder an eine Umgebung abgeben. Gleichzeitig wird durch die Elastizität des dauerelastischen Materials eine eventuelle Fehlausdehnung, also eine schädigungswirksame Differenz der relativen und/oder absoluten thermisch bedingten Längenänderungen des jeweiligen metallischen Trägers einerseits und eines an einer anderen, insbesondere gegenüberliegenden, Seite des dauerelastischen Materials angeordneten weiteren Bauelements der elektrischen Baugruppe vermieden.

Durch die Elastizität des dauerelastischen Materials kann vorteilhaft also auch unter signifikanter thermomechanische Belastung ein optimaler Wärmefluss, also ein effektives und effizientes Ableiten von Verlustwärme aus der elektrischen Baugruppe erreicht werden, da mechanischer Stress ausgeglichen und so ein möglichst guter thermischer und mechanischer Kontakt aufrechterhalten werden kann.

Der metallische Träger kann dabei eine mechanische Stabilität, beispielsweise gegen Verbiegen, ebenso wie einen Schutz vor Beschädigungen durch mechanische Einwirkungen auf die elektrische Baugruppe bieten beziehungsweise verbessern. Dazu kann der metallische Träger bezogen auf eine Mittel- oder Zentralebene der elektrischen Baugruppe insbesondere weiter außen liegend, also weiter von einem Mittelpunkt der elektrischen Baugruppe entfernt, angeordnet sein, als das dauerelastische Material. Das dauerelastische Material kann mit anderen Worten also innen liegend an dem jeweiligen metallischen Träger angeordnet sein. Der metallische Träger kann Teil des jeweiligen ersten beziehungsweise zweiten Verdrahtungsträgers sein. Mit anderen Worten können also das jeweilige dauerelastische Material und der jeweilige metallische Träger zusammen den jeweiligen Verdrahtungsträger bilden.

Selbstverständlich kann der jeweilige Verdrahtungsträger auch noch weitere Komponenten, Elemente oder Bestandteile aufweisen. Ist der jeweilige metallische Träger Teil des jeweiligen Verdrahtungsträgers, so kann vorteilhaft eine besonders hohe Funktionsdichte realisiert werden, da der derart aus mehreren unterschiedlichen Bereichen beziehungsweise Materialien aufgebaute Verdrahtungsträger in einem Bauelement mehrere Funktionen vereinen oder erfüllen kann. Somit kann vorteilhaft ein entsprechendes weiteres Bauteil für zumindest eine dieser Funktionalitäten eingespart werden.

Um eine besonders hohe Funktionsdichte der elektrischen Baugruppe zu erreichen, kann der metallische Träger beispielsweise eine Kühlfunktion übernehmen. Dazu ist es in weiterer vorteilhafter Ausgestaltung der vorliegenden Erfindung vorgesehen, dass der jeweilige metallische Träger als Kühlelement zum Kühlen der elektrischen Baugruppe ausgebildet ist. Mit anderen Worten können also die Funktionalitäten eines Verdrahtungsträgers und eines Kühlelementes durch den vorliegend erfindungsgemäßen Verdrahtungsträger in einem einzigen Bauelement vereint beziehungsweise kombiniert werden. Dass der metallische Träger als Kühlelement ausgebildet ist, kann beispielsweise bedeuten, dass der jeweilige metallische Träger eine Außenseite beziehungsweise Oberfläche der elektrischen Baugruppe bildet, sodass er Wärme an die jeweilige Umgebung der elektrischen Baugruppe abstrahlen oder abgeben kann. Dazu kann die dem dauerelastischen Material abgewandte Außen- oder Oberseite des jeweiligen metallischen Trägers beispielsweise Kühlfinnen aufweisen oder anderweitig ausgeformt sein, um eine vergrößerte Oberfläche und somit eine vergrößerte Wärmeabgabefähigkeit zu erreichen.

Ebenso kann der metallische Träger beispielsweise dazu ausgebildet sein, an einen Kühlkreislauf beziehungsweise einen Kühlmittelkreislauf angeschlossen zu werden. Hierfür kann der metallische Träger beispielsweise entsprechende Aufnahmen oder Befestigungselemente aufweisen, mittels welchen er an eine externe Kühlung oder Kühleinrichtung angeschlossen beziehungsweise mit einer externen Kühlung oder Kühleinrichtung wärmeleitend verbunden werden kann. Aufgrund seiner thermischen Leitfähigkeit und seiner mechanischen Stabilität und Belastbarkeit ist der metallische Träger hierfür besonders geeignet. Ebenso kann der metallische Träger beispielsweise eine Bohrung oder einen Kanal aufweisen, durch welche beziehungsweise durch welchen ein Kühlmittel oder Kühlmedium den metallischen Träger durchströmen kann. So kann ein besonders effizienter Wärmeabtransport erreicht werden.

Gemäß der vorliegenden Erfindung sind in allen Verbindungsebenen der elektrischen Baugruppe, in denen jeweils wenigstens zwei Bauelemente miteinander verbunden sind, die jeweiligen wenigstens zwei Bauelemente unter Verzicht auf eine stoffschlüssige Verbindung kraftschlüssig miteinander verbunden. Mit anderen Worten sind die Bauelemente der elektrischen Baugruppe also durch den Verzicht auf stoffschlüssige Verbindungen zerstörungsfrei voneinander lösbar. Dadurch dass die elektrische Baugruppe durch kraftschlüssig wirkende Aufbau-oder Fügemaßnahmen beziehungsweise -methoden hergestellt und zusammengehalten wird, kann vorteilhaft eine verbesserte thermomechanische, letztlich also auch elektrische, Belastbarkeit der elektrischen Baugruppe insgesamt erreicht werden. Dies ist der Fall, da die kraftschlüssigen Fügungen oder Verbindungen ein Abgleiten der einzelnen Bauelemente aneinander ermöglichen können. Somit können sich also die einzelnen Bauelemente, welche insbesondere unterschiedliche thermische Ausdehnungskoeffizienten und/oder unterschiedliche Temperaturen aufweisen können, individuell unabhängig voneinander ausdehnen oder zusammenziehen, ohne dass dies zu schädigungswirksamem mechanischem Stress beziehungsweise zu entsprechenden mechanischen Spannungen innerhalb der elektrischen Baugruppe führt.

Um trotz des Verzichtes auf ein stoffschlüssiges Fügen die Funktionalität der elektrischen Baugruppe sicherzustellen, können insbesondere elektrische und/oder thermische Kontakte durch kraftschlüssiges Anpressen beziehungsweise Aneinanderpressen geeigneter Kontaktflächen beziehungsweise Kontaktbereiche der jeweiligen Bauelemente realisiert werden. Dies kann dauerhaft beispielsweise durch ein oder mehrere Federelemente, durch eine oder mehrere Klammern, durch eine oder mehrere Schraubverbindungen und/oder dergleichen realisiert werden. Diese Federelemente, Klammern und/oder Schraubverbindungen oder dergleichen können also Teil beziehungsweise Teile der elektrischen Baugruppe sein. Beispiele für Verbindungsebenen in diesem Sinne können eine Ebene, also eine Grenz- oder Verbindungsfläche, in der ein Kühlkörper oder Kühlelement an ein weiter innen liegendes Bauelement der elektrischen Baugruppe angebunden ist ebenso umfassen wie die Ebene, in der das elektrische Schaltelement auf beziehungsweise an seiner Ober- oder Unterseite elektrisch und/oder thermisch kontaktiert ist.

Zusätzlich zu der kraftschlüssigen Verbindung beziehungsweise den kraftschlüssigen Verbindung kann die elektrische Baugruppe eine oder mehrere formschlüssige Verbindungen aufweisen. Hierdurch kann beispielsweise eine Verschiebung zweier Bauelemente relativ zueinander und/oder eine Bewegung eines oder mehrerer Bauelemente innerhalb der elektrischen Baugruppe begrenzt werden, um die vorgegebene Struktur und die Funktionalität der elektrischen Baugruppe dauerhaft aufrecht zu erhalten beziehungsweise zu gewährleisten.

In weiterer vorteilhafter Ausgestaltung der vorliegenden Erfindung bildet das dauerelastische Material des ersten und/oder des zweiten Verdrahtungsträgers eine Schicht, die unmittelbar an der jeweiligen elektrischen Kontaktierung des elektronischen Schaltelements anliegt. Das dauerelastische Material des ersten Verdrahtungsträgers kann also beispielsweise eine elektrische Kontaktierungsschicht oder eine elektrische Leitung tragen oder aufnehmen, mittels welcher die Unterseite des elektronischen Schaltelements elektrisch kontaktiert ist. In entsprechender Weise kann das dauerelastische Material des zweiten Verdrahtungsträgers eine elektrische Kontaktierungsschicht oder eine elektrische Leitung tragen oder aufnehmen, mittels welcher die Oberseite des elektronischen Schaltelements kontaktiert ist.

Das dauerelastische Material der Verdrahtungsträger kann ein das elektronische Schaltelement unterseitig und/oder oberseitig zumindest teilweise umgebendes Dielektrikum sein, also eine dielektrische Schicht oder Lage innerhalb der elektrischen Baugruppe bilden.

Die Anordnung des dauerelastischen Materials unmittelbar an der elektrischen Kontaktierung des elektronischen Schaltelements, also in minimalem Abstand zu diesem, ist zur Verbesserung des thermomechanischen Verhaltens der elektrischen Baugruppe besonders vorteilhaft, da in dem elektronischen Schaltelement die abzuführende Verlustwärme entstehen kann. Durch die Elastizität des dauerelastischen Materials kann zum einen vorteilhaft eine maximale Kontaktfläche zur Wärmeableitung mit minimalem Fertigungsaufwand realisiert werden, da sich das dauerelastische Material beim Fügen der elektrischen Baugruppe und selbst beziehungsweise automatisch an lokale Ausformungen anpasst. Das dauerelastische Material bietet vorteilhaft also eine besonders gute Anformbarkeit, was vorteilhaft zu einem besonders geringen thermischen Widerstand zu und von dem dauerelastischen Material führt.

Zum anderen können an dieser Stelle maximale Temperaturen, Temperaturschwankungen und/oder Temperaturgradienten auftreten. Durch die Anordnung des dauerelastischen Materials unmittelbar an der elektrischen Kontaktierung des elektronischen Schaltelements - und gegebenenfalls auch zumindest bereichsweise an dem elektronischen Schaltelement selbst - können thermomechanische Auswirkungen, wie beispielsweise in herkömmlichen Aufbauten potentiell schädigungswirksame Fehlausdehnungen, besonders vorteilhaft aufgefangen oder ausgeglichen werden.

Während bekannte herkömmliche elektrische Baugruppen oftmals einen asymmetrischen Aufbau aufweisen, kann durch die vorliegende Erfindung vorteilhaft ein symmetrischer Aufbau oder eine symmetrische Struktur der elektrischen Baugruppe realisiert werden. Dabei kann durch die Anordnung des gleichen dauerelastischen Materials sowohl auf oder an der Unterseite als auch auf oder an der Oberseite des elektronischen Schaltelements vorteilhaft eine besonders gleichmäßige Wärmeableitung von dem elektronischen Schaltelement erreicht werde. Durch eine derartige symmetrische Entwärmung des elektrischen Schaltelements kann vorteilhaft das Entstehen eines Temperaturgradienten oder einer thermomechanischen Spannung innerhalb des elektronischen Schaltelements vermieden werden. Dies kann bei herkömmlichen bekannten elektrischen Baugruppen, bei denen beispielsweise einseitig ein Füllmaterial oder eine Vergussmasse an dem elektronischen Schaltelement angeordnet ist, nicht sichergestellt werden, da die unterschiedlichen Materialien an der Oberseite und der Unterseite des elektronischen Schaltelements üblicherweise unterschiedliche Wärmeleitfähigkeiten und Wärmekapazitäten aufweisen.

In weiterer vorteilhafter Ausgestaltung der vorliegenden Erfindung enthält das dauerelastische Material des ersten und/oder des zweiten Verdrahtungsträgers ein Polysiloxan und eine weitere Komponente, insbesondere Metalloxidpartikel und/oder Keramikpartikel. Dies stellt eine erprobte Möglichkeit dar, ein dauerelastisches Material mit den gewünschten thermischen, mechanischen und elektrischen Eigenschaften zu schaffen.

Zusätzlich zu der elektrischen Baugruppe ist ein weiterer Aspekt der vorliegenden Erfindung ein Verfahren zum Herstellen einer elektrischen Baugruppe. Bei dem erfindungsgemäßen Verfahren wird zum Fügen der Baugruppe eine externe Druckkraft auf einen außenliegenden ersten und einen diesem gegenüberliegenden außenliegenden zweiten Verdrahtungsträger der Baugruppe ausgeübt. Die Verdrahtungsträger sind dabei jeweils wenigstens zum Teil aus einem dauerelastischen, elektrisch isolierenden, thermisch leitfähigen Material gebildet. Zwischen den Verdrahtungsträgern ist wenigstens ein elektronisches Schaltelement angeordnet. Durch die Druckkraft werden innerhalb der elektrischen Baugruppe unter Verzicht auf stoffschlüssige Verbindungen thermische und/oder elektrische Kontaktierungen zumindest des wenigstens einen Schaltelements an einer dem ersten Verdrahtungsträger zugewandten Unterseite und einer dem zweiten Verdrahtungsträger zugewandten Oberseite des Schaltelements hergestellt. Das heißt, das Schaltelement und die Verdrahtungsträger werden in direkten oder indirekten Kontakt gebracht.

In vorteilhafter Ausgestaltung des erfindungsgemäßen Verfahrens werden die Bauelemente der Baugruppe so toleriert, dass vor dem Ausüben der Druckkraft ein Mindestmaß der Baugruppe senkrecht zu einer Verbindungsebene zwischen dem wenigstens einen elektronischen Schaltelement und den Verdrahtungsträgern mindestens so groß ist wie ein Soll- oder Höchstmaß der fertigen, das heißt der fertig gefügten, also fertig hergestellten, Baugruppe. Durch die Druckkraft wird das dauerelastische Material des ersten und/oder des zweiten Verdrahtungsträgers zusammengedrückt und/oder verformt und dadurch die Baugruppe auf das Sollmaß gebracht. Mit anderen Worten kann durch die Tolerierung der Bauelemente trotz der sich durch die Vielzahl der unterschiedlichen Bauelemente innerhalb der elektrischen Baugruppe aufbauenden Toleranzkette sichergestellt werden, dass die elektrische Baugruppe vor dem Ausüben der Druckkraft war also vor dem endgültigen Fügen der Baugruppe, diese eine vorgegebene Mindestdicke aufweist. Ein Toleranzband wird dann durch die Elastizität beziehungsweise Verformbarkeit des dauerelastischen Materials bereitgestellt. Dieses Toleranzband kann beim Fügen, also beim Herstellen der Baugruppe dann durch Variation oder Einstellen der externen Druckkraft ausgeschöpft werden.

Die bisher und im Folgenden angegebenen Eigenschaften und Weiterbildungen der erfindungsgemäßen Baugruppe sowie die entsprechenden Vorteile sind jeweils sinngemäß auf das erfindungsgemäße Verfahren und/oder zur Durchführung des erfindungsgemäßen Verfahrens verwendete oder verwendbare Bauteile und Einrichtungen übertragbar und umgekehrt. Es gehören also zu der Erfindung auch solche Weiterbildungen der erfindungsgemäßen Baugruppe und des erfindungsgemäßen Verfahrens, die Ausgestaltungen aufweisen, die hier nicht explizit in der jeweiligen Kombination beschrieben sind.

Weitere Merkmale, Einzelheiten und Vorteile der vorliegenden Erfindung ergeben sich aus der nachfolgenden Beschreibung bevorzugter Ausführungsbeispiele sowie anhand der Zeichnung. Dabei zeigt die einzige Figur eine schematische geschnittene Seitenansicht einer beispielhaften elektrischen Baugruppe mit zwei beidseitig kontaktierten elektronischen Schaltelementen, die zwischen zwei Verdrahtungsträgern, insbesondere zwischen zwei Schichten aus einem dauerelastischen, elektrisch isolierenden, thermisch leitfähigen Material, angeordnet sind.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Die einzige Figur zeigt eine elektrische Baugruppe 1 in einer schematischen und geschnittenen Seitenansicht. Vorliegend umfasst die elektrische Baugruppe 1 zwei jeweils außenliegend angeordnete Verdrahtungsträger 2. Dies sind ein unterer Verdrahtungsträger 3 und ein oberer Verdrahtungsträger 4. Zwischen den Verdrahtungsträgern 2 sind als elektronisches Schaltelement zwei Leistungshalbleiter 5 angeordnet.

Mit der heutzutage zunehmend angestrebten Erhöhung einer Anzahl und Dichte von Funktionen beziehungsweise Funktionalitäten bei gleichzeitiger Miniaturisierung und Leistungssteigerung von elektrischen und elektronischen Baugruppen treten mit bekannten Lösungsansätzen nicht oder nur mit Kompromissen beherrschbare Probleme sowohl bei einer Fertigung als auch bei einem thermomechanischen Verhalten der Baugruppen auf. Bekannte Lösungsansätze zielen im Wesentlichen ab auf eine Beherrschung der jeweiligen Toleranzkette durch eng spezifizierte und zum Teil nur unwirtschaftlich erreichbare Einzeltoleranzen der einzelnen Konstruktion- oder Bauelemente der jeweiligen Baugruppe und damit der einzelnen Kettenglieder der Toleranzkette. Zusätzlich werden mitunter Kompensationsmaßnahmen, wie beispielsweise ein adaptiver Lotauftrag eingesetzt. Durch unterschiedliche thermische Ausdehnungskoeffizienten der Bauelemente bedingte Schädigungswirkungen sollen dabei durch geometrische und werkstoffmäßige Optimierung der Baugruppen beziehungsweise Aufbauten minimiert werden. Hier stößt man heutzutage jedoch an durch die Materialwahl beziehungsweise die verfügbaren Materialien und deren Einsatz bei der Herstellung der jeweiligen Baugruppe an technische und wirtschaftliche Grenzen.

Vorliegend weisen die Verdrahtungsträger 2 jeweils eine dauerelastische Schicht 6 auf. Die jeweilige dauerelastische Schicht 6 ist dabei innenliegend an den Verdrahtungsträgern 2, das heißt auf einer jeweils den Leistungshalbleitern 5 zugewandten Seite, angeordnet. Die dauerelastischen Schichten 6 sind aus einem dauerelastischen, elektrisch isolierenden aber dennoch thermisch gut leitenden Material gefertigt. Ein solches Material kann beispielsweise aus einem Polysiloxan und einem Keramikfiller oder aus einem Polysiloxan und Aluminiumoxidpartikeln gebildet sein. Ein geeignetes Material ist beispielsweise unter dem Markennamen Keratherm bekannt.

Dass die dauerelastischen Schichten 6 beziehungsweise deren Material thermisch gut leitfähig ist, kann zum Beispiel bedeuten, dass die jeweilige dauerelastische Schicht 6 beziehungsweise deren Material eine Wärmeleitfähigkeit von wenigstens 2 W/(m·K) und bevorzugt von wenigstens 5 W/(m·K) aufweist.

Innenseitig der dauerelastischen Schichten 6 sind zwischen diesen und den Leistungshalbleitern 5 elektrische Kontaktierungen der Leistungshalbleiter 5 angeordnet. Diese Kontaktierungen sind zwischen dem unteren Verdrahtungsträger 3 und den Leistungshalbleitern 5 eine untere Kontaktierung 7 und zwischen dem oberen Verdrahtungsträger 4 und den Leistungshalbleitern 5 eine obere Kontaktierung 8. Die Kontaktierungen 7, 8 können beispielsweise in einem herkömmlichen Planarprozess aufgebrachte Kupferschichten sein.

Bauelemente der elektrischen Baugruppe 1 sind im vorliegenden Beispiel also zumindest die Verdrahtungsträger 2, die dauerelastischen Schichten 6 und die Leistungshalbleiter 5. Auch die elektrischen Kontaktierungen 7, 8 können als Bauelemente aufgefasst werden, da es sich hierbei um separate spezifische Schichten handeln kann. Bevorzugt sind die Bauelemente der elektrischen Baugruppe 1 nicht stoffschlüssig miteinander verbunden. Vielmehr wird ein Zusammenhalt der elektrischen Baugruppe 1 durch kraftschlüssige Verbindungen erzielt.

Zum Fügen der elektrischen Baugruppe 1 wird eine Fügekraft 9, deren Richtung hier schematisch durch Pfeile veranschaulicht ist, auf einen oder beide der Verdrahtungsträger 2 ausgeübt. Durch die Fügekraft 9 kann die elektrische Baugruppe insgesamt und insbesondere das Material der dauerelastischen Schichten 6 zusammengedrückt werden. Dies ermöglicht während der Fertigung auf einfache Weise einen Toleranzausgleich, um ein vor dem Ausüben der Fügekraft 9 bestehendes Istmaß der elektrischen Baugruppe 1 in Richtung der Fügekraft 9 auf ein vorgegebenes Sollmaß zu bringen. Dazu kann die Fügekraft individuell auf die jeweilige elektrische Baugruppe 1 abgestimmt gesteuert beziehungsweise eingestellt werden. Es kann dazu möglich sein, vor und/oder während des Ausübens der Fügekraft 9 das Istmaß der elektrischen Baugruppe 1 zu messen beziehungsweise zu überwachen. Vorteilhaft wird durch die Elastizität der dauerelastischen Schichten 6 dabei die Fügekraft 9 besonders gleichmäßig verteilt, wodurch mechanische Beschädigungen beispielsweise der Kontaktierungen 7, 8 oder der Leistungshalbleiter 5 vermieden werden können.

Sowohl durch die Elastizität der dauerelastischen Schichten 6 als auch durch den Verzicht auf stoffschlüssige Verbindungen zwischen den Bauelementen, also in den Verbindungsebenen der elektrischen Baugruppe 1 kann bei einem Betrieb der elektrischen Baugruppe 1 ein Aufbau von thermisch induzierten mechanischen Spannungen vermieden oder zumindest verringert werden. Solche thermomechanischen Spannungen können insbesondere bei unterschiedlichen thermischen Ausdehnungskoeffizienten (CTE, englisch: "coeffizient of thermal expansion") unterschiedlicher, insbesondere benachbarter Bauelemente auftreten und dann zu Fehlausdehnungen, also unterschiedlich starken Längenänderungen der Bauelemente, führen, was letztlich die elektrische Baugruppe 1 beschädigen kann.

Solche Fehlausdehnungen durch unterschiedliche thermische Ausdehnungskoeffizienten (CTE-Mismatch) können durch die dauerelastischen Schichten 6 aufgefangen werden. Beispielsweise kann ein jeweiliger, den Leistungshalbleitern 5 und den dauerelastischen Schichten 6 abgewandter Bereich der Verdrahtungsträger 2 aus einem metallischen Werkstoff, beispielsweise Aluminium, gebildet sein. Diese Bereiche können dann als Kühlelemente zum Kühlen der elektrischen Baugruppe 1 dienen. Erwärmen sich bei einem Betrieb der elektrischen Baugruppe 1 jedoch diese metallischen oder Aluminiumbereiche, so dehnen diese sich aus und zwar insbesondere stärker als beispielsweise die Leistungshalbleiter 5, welche vorwiegend aus Silizium und Siliziumoxiden gebildet sein können. Die größere thermische Ausdehnung beziehungsweise Längenänderung der metallischen oder Aluminiumbereiche der Verdrahtungsträger 2 führt dann zu einer Verformung beziehungsweise zu einem Walken der dauerelastischen Schichten 6 und wird nicht oder zumindest nicht in vollem Umfang an die Leistungshalbleiter 5 weitergegeben.

Durch den Verzicht auf stoffschlüssige Verbindungen in den jeweiligen Verbindungsebenen können die einzelnen Bauelemente zudem aneinander entlang oder aneinander ab-gleiten in sich in der jeweiligen Verbindungsebene beziehungsweise parallel dazu erstreckende Richtungen. Die Verbindungsebenen der elektrischen Baugruppe 1 erstrecken sich dabei vorliegend senkrecht zu einer Zeichenebene zwischen jeweils zwei benachbarten Bauelementen. Dieses einem Ausgleich von thermomechanischen Spannungen dienende Abgleiten oder unabhängige Ausdehnen beziehungsweise Zusammenziehen der Bauelemente parallel zu den Verbindungsebenen ist hier schematisch durch einen Doppelpfeil 10 angedeutet.

Die vorliegend gezeigte Darstellung der elektrischen Baugruppe 1 ist lediglich als ein beispielhafter Aufbau zu verstehen. Selbstverständlich sind ebenso andere, auch komplexere, Strukturen und Anordnungen möglich. So können beispielsweise weitere Schichten oder Bereiche aus dem dauerelastischen Material der dauerelastischen Schichten 6 vorgesehen sein, um beispielsweise zwischen weiteren Bauelementen andernfalls auftretende Fehlausdehnungen abzufangen.

### Bezugszeichenliste

- 1: Elektrische Baugruppe
- 2: Verdrahtungsträger
- 3: unterer Verdrahtungsträger
- 4: oberer Verdrahtungsträger
- 5: Leistungshalbleiter
- 6: dauerelastische Schicht
- 7: untere Kontaktierung
- 8: obere Kontaktierung
- 9: Fügekraft
- 10: Doppelpfeil

## Patentansprüche

1. Elektrische Baugruppe (1), aufweisend ein elektronisches Schaltelement (5), das an seiner Unterseite elektrisch kontaktiert (7), auf einem flexiblen ersten Verdrahtungsträger (3) der elektrischen Baugruppe (1) angeordnet ist und wenigstens einen Leistungshalbleiter (5) aufweist, wobei
- das elektronische Schaltelement (5) zusätzlich auf einer der Unterseite gegenüberliegenden Oberseite elektrisch kontaktiert ist (8),
- die elektrische Baugruppe (1) einen zweiten Verdrahtungsträger (4) aufweist, der dem ersten Verdrahtungsträger (3) gegenüberliegend an der oberseitigen elektrischen Kontaktierung (8) des elektronischen Schaltelements (5) angeordnet ist,
- der erste und der zweite Verdrahtungsträger (3, 4) jeweils wenigstens zum Teil aus einem dauerelastischen, elektrisch isolierenden, thermisch leitfähigen Material (6) gebildet sind, **gekennzeichnet dadurch, dass**
- in allen Verbindungsebenen der elektrischen Baugruppe (1), in denen jeweils wenigstens zwei Bauelemente (2, 3, 4, 5, 6, 7, 8) miteinander verbunden sind, die jeweiligen Bauelemente (2, 3, 4, 5, 6, 7, 8) unter Verzicht auf eine stoffschlüssige Verbindung kraftschlüssig miteinander verbunden sind.

2. Elektrische Baugruppe (1) nach einem der vorhergehenden Ansprüche, **dadurch gekennzeichnet, dass**
das dauerelastische Material (6) des ersten und/oder des zweiten Verdrahtungsträgers (3, 4) auf einen metallischen Träger aufgedrückt ist.

3. Elektrische Baugruppe (1) nach Anspruch 2, **dadurch gekennzeichnet, dass**
der jeweilige metallische Träger als Kühlelement zum Kühlen der elektrischen Baugruppe (1) ausgebildet ist.

4. Elektrische Baugruppe (1) nach einem der vorhergehenden Ansprüche, **dadurch gekennzeichnet, dass**
das dauerelastische Material (6) des ersten und/oder des zweiten Verdrahtungsträgers (2, 3, 4) ein Polysiloxan und eine weitere Komponente, insbesondere Metalloxidpartikel und/oder Keramikpartikel, enthält.

5. Verfahren zum Herstellen einer elektrischen Baugruppe (1), bei dem
- zum Fügen der Baugruppe (1) eine externe Druckkraft (9) auf einen außenliegenden ersten und einen diesem gegenüberliegenden außenliegenden zweiten Verdrahtungsträger (3, 4) der Baugruppe (1), die jeweils wenigstens zum Teil aus einem dauerelastischen, elektrisch isolierenden, thermisch leitfähigen Material (6) gebildet sind, ausgeübt wird, wobei zwischen den Verdrahtungsträgern (3, 4) wenigstens ein elektronisches Schaltelement (5) angeordnet ist, und
- durch die Druckkraft (9) innerhalb der Baugruppe (1) unter Verzicht auf stoffschlüssige Verbindungen thermische und/oder elektrische Kontaktierungen zumindest des wenigstens einen Schaltelements (5) an einer dem ersten Verdrahtungsträger (3) zugewandten Unterseite und einer dem zweiten Verdrahtungsträger (4) zugewandten Oberseite des Schaltelements (5) hergestellt werden.

6. Verfahren nach Anspruch 5, **dadurch gekennzeichnet, dass**
- die Bauelemente (2, 3, 4, 5, 6, 7, 8) der Baugruppe (1) so toleriert werden, dass vor dem Ausüben der Druckkraft (9) ein Mindestmaß der Baugruppe (1) senkrecht zu einer Verbindungsebene zwischen dem wenigstens einen elektronischen Schaltelement (5) und den Verdrahtungsträgern (2, 3, 4) mindestens so groß ist wie ein Soll- oder Höchstmaß der fertigen Baugruppe (1), und
- durch die Druckkraft (9) das dauerelastische Material (6) des ersten und/oder des zweiten Verdrahtungsträger (2, 3, 4) verformt und dadurch die Baugruppe (1) auf das Sollmaß gebracht wird.

## Claims

1. Electrical assembly (1), having an electronic switching element (5), which is electrically contacted (7) on its underside and is arranged on a flexible first wiring support (3) of the electrical assembly (1) and has at least one power semiconductor (5), wherein
- the electronic switching element (5) is additionally electrically contacted (8) on an upper side lying opposite the underside,
- the electrical assembly (1) has a second wiring support (4), which is arranged lying opposite the first wiring support (3) on the upper side electrical contacting area (8) of the electronic switching element (5),
- the first and the second wiring supports (3, 4) are each formed at least in part from a permanently elastic, electrically insulating, thermally conductive material (6), **characterised in that**
- in all connection planes of the electrical assembly (1), in which in each case at least two components (2, 3, 4, 5, 6, 7, 8) are connected to one another, the respective components (2, 3, 4, 5, 6, 7, 8) are connected to each other by a force fit while foregoing an integrally bonded connection.

2. Electrical assembly (1) according to one of the preceding claims,
**characterised in that**
the permanently elastic material (6) of the first and/or of the second wiring support (3, 4) is pressed onto a metallic support.

3. Electrical assembly (1) according to claim 2,
**characterised in that**
the respective metallic support is embodied as a cooling element for cooling the electrical assembly (1).

4. Electrical assembly (1) according to one of the preceding claims,
**characterised in that**
the permanently elastic material (6) of the first and/or the second wiring support (2, 3, 4) contains a polysiloxane and a further component, in particular metal oxide particles and/or ceramic particles.

5. Method for producing an electrical assembly (1), in which
- to join the assembly (1) together, an external compressive force (9) is exerted on a first outer wiring support (3, 4) of the assembly (1) and on a second outer wiring support (3, 4) lying opposite the first one, which are each formed at least in part from a permanently elastic, electrically insulating, thermally conductive material (6), wherein at least one electronic switching element (5) is arranged between the wiring supports (3, 4), and
- through the compressive force (9) within the assembly (1), while foregoing integrally bonded connections, thermal and/or electrical contacting at least of the at least one switching element (5) is established on an underside facing towards the first wiring support (3) and on an upper side of the switching element (5) facing towards the second wiring support (4).

6. Method according to claim 5,
**characterised in that**
- the components (2, 3, 4, 5, 6, 7, 8) of the assembly (1) are provided with tolerances so that, before the compressive force (9) is exerted, a minimum dimension of the assembly (1) at right angles to a connection plane between the at least one electronic switching element (5) and the wiring supports (2, 3, 4) is at least as large as a required or maximum dimension of the completed assembly (1), and
- through the compressive force (9) the permanently elastic material (6) of the first and/or of the second wiring support (2, 3, 4) is deformed and the assembly (1) is thereby set to the required dimension.

## Revendications

1. Module (1) électrique, comportant un élément (5) électronique de coupure, qui est mis en contact (7) électriquement sur son côté inférieur, qui est disposé sur un premier support (3) de câblage souple du module (1) électrique et qui a au moins un semiconducteur (5) de puissance, dans lequel
- l'élément (5) électronique de coupure est mis en contact (8) électriquement supplémentairement sur un côté supérieur opposé au côté inférieur,
- le module (1) électrique a un deuxième support (4) de câblage, qui est disposé à l'opposé du premier support (3) de câblage sur la mise en contact (8) électrique du côté supérieur de l'élément (5) électronique de coupure,
- le premier et le deuxième supports (3, 4) de câblage sont formés respectivement au moins en partie en un matériau (6) à élasticité permanente, isolant électriquement et conducteur thermiquement, **caractérisé en ce que**
- dans tous les plans de connexion du module (1) électrique, dans lesquels respectivement au moins deux composants (2, 3, 4, 5, 6, 7, 8) sont connectés entre eux, les composants (2, 3, 4, 5, 6, 7, 8) respectifs sont reliés entre eux à coopération de force en renonçant à une liaison à coopération de matière.

2. Module (1) électrique suivant l'une des revendications précédentes,
**caractérisé en ce que** le matériau (6) à élasticité permanente du premier et/ou du deuxième supports (3, 4) de câblage est imprimé sur un support métallique.

3. Module (1) électrique suivant la revendication 2,
**caractérisé en ce que** le support métallique respectif est constitué en élément de refroidissement pour le refroidissement du module (1) électrique.

4. Module (1) électrique suivant l'une des revendications précédentes, **caractérisé en ce que**
le matériau (6) à élasticité permanente du premier et/ou du deuxième support (2, 3, 4) de câblage contient un polysiloxane et un autre composant, en particulier des particules d'oxyde métallique et/ou des particules de céramique.

5. Procédé de fabrication d'un module (1) électrique, dans lequel
- pour l'assemblage du module (1), on applique une force (9) extérieure de pression à un premier, se trouvant à l'extérieur, et un deuxième supports (3, 4) de câblage, se trouvant à l'extérieur et opposé à celui-ci, du module (1), qui sont formés respectivement au moins en partie en un matériau (6) à élasticité permanente, isolant électriquement et conducteur thermiquement, dans lequel, entre les supports (3, 4) de câblage est disposé au moins un élément (5) électronique de coupure, et
- par la force (9) de pression, on produit, à l'intérieur du module (1) en renonçant à des liaisons à coopération de matière, des mises en contact thermiques et/ou électriques au moins du au moins un élément (5) de coupure à un côté inférieur tourné vers le premier support (3) de câblage et à un côté supérieur tourné vers le deuxième support (4) de câblage de l'élément (5) de coupure.

6. Procédé suivant la revendication 5, **caractérisé en ce que**
- l'on admet des tolérances pour les composants (2, 3, 4, 5, 6, 7, 8) du module (1) de manière à ce que, avant l'application de la force (9) de pression, une dimension minimum du module (1) perpendiculairement à un plan de liaison entre l'élément (5) électronique de coupure et les supports (2, 3, 4) de câblage, soit au moins aussi grande qu'une dimension de consigne ou la plus grande du module (1) fini, et
- par la force (9) de pression, on déforme la matière (6) à élasticité permanente du premier et/ou du deuxième supports (2, 3, 4) de câblage et on met ainsi le module (1) à la dimension de consigne.
